(19) Europäisches Patentamt
European Patent Office
Office européen des brevets

(11) **EP 4 624 944 A1**

(12) **EUROPÄISCHE PATENTANMELDUNG**

(43) Veröffentlichungstag:
**01.10.2025  Patentblatt 2025/40**

(21) Anmeldenummer: **25160148.0**

(22) Anmeldetag: **26.02.2025**

(51) Internationale Patentklassifikation (IPC):
**G01R 27/02** *(2006.01)*   **G01R 31/28** *(2006.01)*
**G01R 27/18** *(2006.01)*

(52) Gemeinsame Patentklassifikation (CPC):
**G01R 27/18; G01R 27/02; G01R 31/2846**

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**GE KH MA MD TN**

(30) Priorität: **25.03.2024  DE 102024108470**

(71) Anmelder: **Bender GmbH & Co. KG
35305 Grünberg (DE)**

(72) Erfinder: **REITZ, Julian
35305 Grünberg (DE)**

(74) Vertreter: **advotec.
Patent- und Rechtsanwaltspartnerschaft mbB
Georg-Schlosser-Straße 6
35390 Gießen (DE)**

(54) **ANORDNUNG UND VERFAHREN ZUR SIMULATION EINES UNGEERDETEN STROMVERSORGUNGSSYSTEMS**

(57) Die Erfindung betrifft eine Simulationsanordnung (10) sowie ein der Simulationsanordnung (10) zugrundeliegendes Verfahren zur Simulation eines ungeerdeten Stromversorgungssystems (2). Dabei erfolgt ein Nachbilden der elektrischen Eigenschaften des ungeerdeten Stromversorgungssystems (2) mittels eines Zweipols (12), wobei der aktiv als 4-Quadranten-Verstärker (14) ausgeführte Zweipol (12) mittels eines spannungsgesteuerten Stromregelkreises (20) angesteuert wird.

**Fig. 2**

EP 4 624 944 A1

**Beschreibung**

Die Erfindung betrifft eine Simulationsanordnung eines ungeerdeten Stromversorgungssystems, mit einem Zweipol zur Nachbildung der elektrischen Eigenschaften des ungeerdeten Stromversorgungssystems, sowie ein Verfahren zur Simulation eines ungeerdeten Stromversorgungssystems.

Bei erhöhten Anforderungen an die Betriebs-, Brand-und Berührungssicherheit elektrischer Anlagen kommt die Netzform eines ungeerdeten Stromversorgungssystems zum Einsatz, die auch als isoliertes Netz (frz. "Isolé Terre"-IT) oder als IT-Stromversorgungssystem bezeichnet wird. Bei dieser Art des Stromversorgungssystems sind die aktiven Teile von dem Erdpotential - gegen Erde - getrennt. Die Körper der angeschlossenen elektrischen Verbraucher sind einzeln oder gemeinsam geerdet. Der Vorteil dieser Netze liegt darin, dass bei einem ersten Isolationsfehler die Funktion der angeschlossenen elektrischen Verbraucher nicht beeinträchtigt wird und somit trotz des fehlerhaften Zustands der Isolierung ein Weiterbetrieb möglich ist, da sich wegen des im Idealfall unendlich großen elektrischen Widerstands zwischen einem aktiven Leiter des Netzes und Erdpotential (Isolationswiderstand) kein geschlossener Stromkreis ausbilden kann. Der Isolationswiderstand weist elektrische Eigenschaften mit kapazitivem und resistivem Charakter auf und wird daher auch als Isolationsimpedanz oder Netzimpedanz bezeichnet.

Da durch einen möglichen weiteren Fehler (Isolationsfehler) an einem anderen aktiven Leiter eine Fehlerschleife entstünde und der dabei fließende Fehlerstrom in Verbindung mit einer Überstromschutzeinrichtung eine Abschaltung der Anlage mit Betriebsstillstand zur Folge hätte, muss der Isolationswiderstand des ungeerdeten Stromversorgungssystems ständig überwacht werden.

Ferner können zwischen aktiven Leitern und Erdpotential Spannungen und Ströme als unerwünschte Störgrößen eingeprägt werden, die unabhängig von der Netzimpedanz sind und zum Beispiel durch den Einsatz von Stromrichterschaltungen entstehen, aber die elektrischen Eigenschaften des ungeerdeten Stromversorgungssystems mitbestimmen.

Zur Überwachung des Isolationswiderstands werden Isolationsüberwachungsgeräte (IMDs) eingesetzt. Aus dem Stand der Technik bekannte Isolationsüberwachungsgeräte werden zwischen den aktiven Leitern einerseits und Erde andererseits angeschlossen und überlagern dem Netz eine vorzugsweise impulsförmige Messspannung (Messpulse). Bei Auftreten eines Isolationsfehlers schließt sich der Messkreis zwischen Netz und Erde über den Isolationsfehler, sodass sich ein dem Isolationsfehler proportionaler Messstrom einstellt. Dieser Messstrom verursacht an einem Messwiderstand in dem Isolationsüberwachungsgerät einen entsprechenden Spannungsabfall, der von einer Elektronik ausgewertet wird und bei Überschreiten eines voreinstellbaren Grenzwertes zu einer Alarmmeldung führt.

Bei der Entwicklung eines Isolationsüberwachungsgerätes müssen verschiedene Betriebspunkte eines IT-Netzes angefahren werden, um die IMDs und die damit implementierten Messalgorithmen auf ihre Funktionsfähigkeit und Leistungsfähigkeit zu überprüfen. Auch bei Produkteinführungen werden zu Demonstrationszwecken verschiedene Betriebspunkte eines IT-Netzes und die Reaktion des IMD vorgeführt, einerseits um Verständnis für ungeerdete Stromversorgungssysteme zu schaffen, anderseits um die Vorzüge gegenüber Mitbewerbergeräten aufzuzeigen. In den seltensten Fällen aber stehen dazu beliebig viele IT-Netze unterschiedlichster Eigenschaften zur Verfügung, sondern es werden die elektrischen Eigenschaften von IT-Netzen mit diskreten Bauelementen wie Kapazitäten, Widerständen und Fremdspannungen in Form von Zweipolen nachgebildet. Nur durch diese Herangehensweise mit definierten Eingangsparametern ist es möglich, Messergebnisse des IMD verifizieren und beurteilen zu können.

Nach dem Stand der Technik und gängiger betrieblicher Praxis werden diskrete Bauelemente verwendet, um Widerstand und Kapazität als maßgebliche elektrische Eigenschaft des IT-Netzes in Hinblick auf die Anwendung eines IMD nachzubilden. Ergänzend und nach Bedarf werden Fremdspannungen (u.a. Gleichtaktspannungen) und die Betriebsspannung des ungeerdeten Netzes mit Spannungsquellen realisiert.

In ersten Entwicklungsstufen oder bei einfachen Versuchen werden üblicherweise handbedienbare Geräte - also R- und C-Dekaden sowie herkömmliche Spannungsquellen verwendet. Bei umfangreicheren Versuchsreihen kommen automatisierte Versionen zum Einsatz.

Als nachteilig erweist sich dabei die Vielzahl der Schaltvorgänge, um gezielt Widerstands- und Kapazitätswerte vorgeben zu können. Besonders das (Um-)Schalten von Kapazitäten bereitet technische Probleme, da hohe Ladeströme fließen können, welche das Schaltorgan, wie beispielsweise einen Halbleiterschalter oder einen elektromechanischen Schalter, an seine Belastungsgrenze bringen kann. Insbesondere werden die diskreten Kondensatoren durch diese Umschaltvorgänge stark belastet und altern entsprechend schneller. Ein Schalten im spannungsfreien Zustand würde zwar die Problematik lösen, stellt jedoch nicht den realen Fall dar.

Auch gestaltet sich das zeitliche Zusammenspiel der einzelnen Komponenten für R, C und U als schwierig, da bei einer zentralen Ansteuerung der automatisierten Dekaden und steuerbaren Spannungsquellen immer eine Latenz zwischen den einzelnen Ansteuersignalen und der Reaktion des entsprechenden Gerätes auftritt.

Als Stand der Technik ist zur Funktionsprüfung eines Isolationsüberwachungsgeräts aus der Patentschrift EP 3 246 715 B1 ein Verfahren und eine Vorrichtung bekannt, bei der ein IMD unter Betriebsbedingungen durch Aufschalten eines zwischen zwei Werten veränderlichen Isolationswiderstands getestet wird.

Die Patentschrift DE 10 2020 111 807 B9 beschreibt eine elektrische Vorrichtung zur Prüfung von Überwachungsgeräten in elektrischen Stromversorgungen durch Variation eines Widerstandswertes. Der Widerstand wird mittels einer Nachbildung auf Basis von Feldeffekttransistoren mit geregeltem ohmschem Verhalten gebildet und ist stufenlos zur Laufzeit einstellbar.

Beide vorgenannten Druckschriften beziehen sich jedoch nur auf die Simulation eines reellen Isolationswiderstands in bestehenden ungeerdeten Netzen - Kapazitätsänderungen und Fremdspannungen werden darin jeweils nicht betrachtet.

Der vorliegenden Erfindung liegt somit die Aufgabe zugrunde, eine Anordnung und ein Verfahren zu konzipieren, mit denen die Funktionsfähigkeit eines Isolationsüberwachungsgerätes für ungeerdete Stromversorgungssysteme über einen breiten Anwendungsbereich hinweg flexibel und effektiv geprüft und demonstriert werden kann.

Diese Aufgabe wird für eine Simulationsanordnung mit einem Zweipol zur Nachbildung der elektrischen Eigenschaften des ungeerdeten Stromversorgungssystems dadurch gelöst, dass der Zweipol aktiv als 4-Quadranten-Verstärker ausgeführt ist und dass die Simulationsanordnung einen spannungsgesteuerten Stromregelkreis aufweist, der den 4-Quadranten-Verstärker ansteuert.

Die erfindungsgemäße Simulationsanordnung beruht auf dem Grundgedanken, den Zweipol aktiv als 4-Quadranten-Verstärker (4QV) auszuführen und diesen mit einem spannungsgesteuerten Stromregelkreis anzusteuern. Mit der Realisierung und Anwendung dieses Konzeptes, insbesondere durch das Zusammenwirken des spannungsgesteuerten Stromregelkreises mit dem 4-Quadranten-Verstärker, ist es möglich, die elektrischen Eigenschaften des ungeerdeten Stromversorgungssystems über einen weiten Anwendungsbereich mit beliebigen und stufenlos einstellbaren Betriebspunkten zu simulieren.

Der 4-Quadranten-Verstärker ist eine elektronische Schaltung, welche sowohl als Quelle, als auch als Senke arbeiten kann, d.h. es wird Leistung aufgenommen und abgegeben. Diese Eigenschaft erweist sich als vorteilhaft, um die elektrischen Vorgänge zwischen aktiven Leitern und Erdpotential im IT-Netz umfassend nachzubilden.

Mit der erfindungsgemäßen Simulationsanordnung können somit beliebige elektrische Zustände des IT-Netzes und deren Auswirkungen auf den Messkreis eines IMD ohne diskrete Bauteile nachgebildet werden. Dies löst in vorteilhafterweise die mit diskreten Kapazitäten oder Induktivitäten und deren Umschaltvorgängen verbundenen Probleme.

Ferner stellt es sich als Vorteil heraus, dass es keine Latenz in der Einstellung der einzelnen Nachbildungs-Elemente, wie z. B. R, C und U gibt, da sich die hier beschriebene Simulationsanordnung auf einen einzigen 4-Quadranten-Verstärker als zu steuerndes Hardwareelement bezieht. Dazu zählt auch, dass alle Einstellungen zur Laufzeit ohne Spannungsfreischaltung vorgenommen werden können.

Vorteilhaft gestaltet sich ebenso, dass grundsätzlich keine nachteilige Diskretisierung von Einstellwerten der einzelnen Parameter notwendig ist. Die Baugröße der Simulationsanordnung hängt im Gegensatz zu steuerbaren Dekaden nicht mit der Schrittweite der Einstellwerte zusammen.

In weiterer Ausgestaltung weist der spannungsgesteuerte Stromregelkreis auf: ein Zweipol-Modell, welches das ungeerdete Stromversorgungssystem beschreibt und eine von dem 4-Quadranten-Verstärker zurückgeführte gemessene Ausgangsspannung in einen Sollstrom transformiert, ein Vergleichsglied, welches den Sollstrom mit einem von dem 4-Quadranten-Verstärker zurückgeführten gemessenen Ausgangsstrom vergleicht und eine Regelabweichung bildet, und einen Regler, der aus der Regelabweichung eine Steuerspannung zur Ansteuerung des 4-Quadranten-Verstärkers berechnet.

Ausgangspunkt des spannungsgesteuerten Stromregelkreises bildet das Zweipol-Modell, welches das Verhalten eines zugrunde gelegten ungeerdeten Stromversorgungssystem beschreibt. Das Zweipol-Modell stellt einen Sollstrom des modellierten ungeerdeten Stromversorgungssystems als Führungsgröße des Regelkreises bereit. Auf Basis vorgegebener Widerstands-, Kapazitäts- und Spannungswerte sowie der von dem 4-Quadranten-Verstärker zurückgeführten gemessenen Ausgangsspannung wird der Sollstrom ermittelt.

Ein nachfolgendes Vergleichsglied vergleicht den Sollstrom mit einem von dem 4-Quadranten-Verstärker zurückgeführten gemessenen Ausgangsstrom und bildet die Regelabweichung, welche einem Regler zugeführt wird.

Der Regler berechnet aus der Regelabweichung eine Steuerspannung zur Ansteuerung des 4-Quadranten-Verstärkers.

Mit Vorteil ist der spannungsgesteuerte Stromregelkreis als Mikrocontroller ausgeführt.

Die in dem spannungsgesteuerten Stromregelkreis auszuführenden Rechenoperationen werden im Hinblick auf die Flexibilität und Anpassungsfähigkeit der Vorgabewerte und der Regelalgorithmen in einem Mikrocontroller ausgeführt. Als Schnittstellen, die vorzugsweise als Peripheriefunktionen auf dem Mikrocontroller implementiert sind, weist der Mikrocontroller zwei Analog-Digital-Umsetzer zur Rückmessung der Ausgangsspannung und des Ausgangsstroms sowie einen Digital-Analog-Umsetzer zur Ansteuerung des 4-Quadranten-Verstärkers mit der Steuerspannung auf.

Bevorzugt beschreibt das Zweipol-Modell ein Ersatzschaltbild des ungeerdeten Stromversorgungssystems und ist als Differenzengleichung zur Berechnung des Sollstroms implementiert.

Dem Zweipol-Modell liegt ein Ersatzschaltbild des ungeerdeten Stromversorgungssystems zugrunde. Die in dem Ersatzschaltbild enthaltenen schaltungstechnischen Informationen nutzt der 4-Quadranten-Verstärker zur Nachbildung eines Stromverlaufs.

Das Ersatzschaltbild besteht aus einem Netzwerk mit Widerstands- und Kapazitätselementen sowie aus Spannungsquellen und wird mathematisch durch Strom-Spannungsbeziehungen beschrieben. Aus den Strom-Spannungsbeziehungen wird in zeitdiskreter Darstellung in Form einer Differenzengleichung der Sollstrom berechnet.

Mit Vorteil ist der Regler als PID-Regler ausgeführt.

Als Regler gelangt vorzugsweise ein adaptiver PID-Regler zur Anwendung, der neben seinem proportionalen Verhalten einen überlagerten Integralanteil aufweist und damit keine bleibende Regelabweichung aufweist. Ein PD-Anteil verbessert das dynamische Verhalten.

Der Regler kann jedoch zur Erfüllung vorgeschriebener regelungstechnischer Anforderungen bezüglich des statischen und dynamischen Regelverhaltens grundsätzlich eine beliebige Übertragungsfunktion annehmen.

Die Verwendung der zuvor beschriebenen erfindungsgemäßen Simulationsanordnung beruht auf der in dem unabhängigen Verfahrensanspruch beschriebenen technischen Lehre, die durch Ansteuern eines aktiv als 4-Quadranten-Verstärker ausgeführten Zweipols mittels eines spannungsgesteuerten Stromregelkreises gekennzeichnet ist. Insoweit treffen auch die vorgenannten technischen Wirkungen und daraus entstehenden verfahrenstechnischen Vorteile auf die Verfahrensmerkmale zu.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:

**Fig. 1:** ein ungeerdetes Stromversorgungssystem mit Isolationsüberwachungsgerät,

**Fig. 2:** eine erfindungsgemäße Simulationsanordnung,

**Fig. 3:** den Arbeitsbereich eines 4-Quadranten-Verstärkers,

**Fig. 4:** ein Ersatzschaltbild des ungeerdeten Stromversorgungssystems,

**Fig. 5:** eine Realisierung des spannungsgesteuerten Stromregelkreises als Mikrocontroller,

**Fig. 6:** einen Aufbau eines Prüfstands mit zwei erfindungsgemäßen Simulationsanordnungen,

**Fig. 7:** ein Simulationsergebnis mit rein ohmschem Verhalten,

**Fig. 8:** ein Simulationsergebnis mit ohmschem und kapazitivem Verhalten und

**Fig. 9:** ein Simulationsergebnis mit ohmschem Verhalten und Fremdspannung.

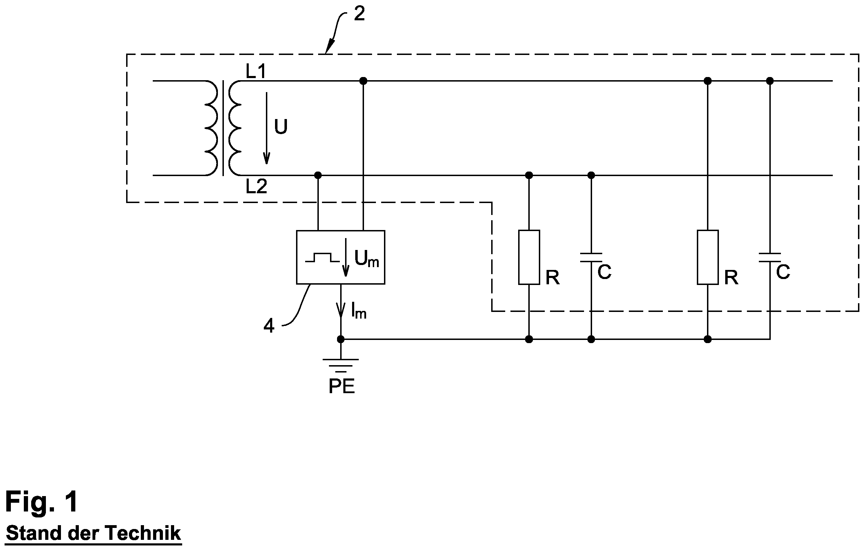

**Fig. 1** zeigt ein ungeerdetes Stromversorgungssystem 2 mit Isolationsüberwachungsgerät 4 um die Bedeutung der Isolationsüberwachung in ungeerdeten Stromversorgungssystemen 2 hervorzuheben.

Das ungeerdete Stromversorgungssystem 2 weist beispielhaft zwei aktive Leiter L1 und L2 auf, zwischen denen die Netzspannung U zur Versorgung angeschlossener Verbraucher bereitgestellt wird. Die elektrischen Eigenschaften des ungeerdeten Stromversorgungssystems 2 sind für die aktiven Leiter L1, L2 gegenüber Erde PE jeweils durch die komplexen Isolationsimpedanzen, bestehend aus dem reellen Isolationswiderstand R und der Ableitkapazität C, charakterisiert.

Zwischen die aktiven Leiter L1, L2 und Erde PE ist das Isolationsüberwachungsgerät 4 angekoppelt. Das Isolationsüberwachungsgerät 4 überlagert dem ungeerdeten Stromversorgungssystem 2 eine Messspannung $U_m$, wobei sich ein Stromkreis mit dem Messstrom $I_m$ über die Parallelschaltung der komplexen Isolationsimpedanzen schließt. Aus der Höhe des Messstroms $I_m$ können in dem Isolationsüberwachungsgerät 4 der Isolationswiderstand R und - je nach Ausstattung des Isolationsüberwachungsgerätes 4 - auch die Ableitkapazität C ermittelt werden.

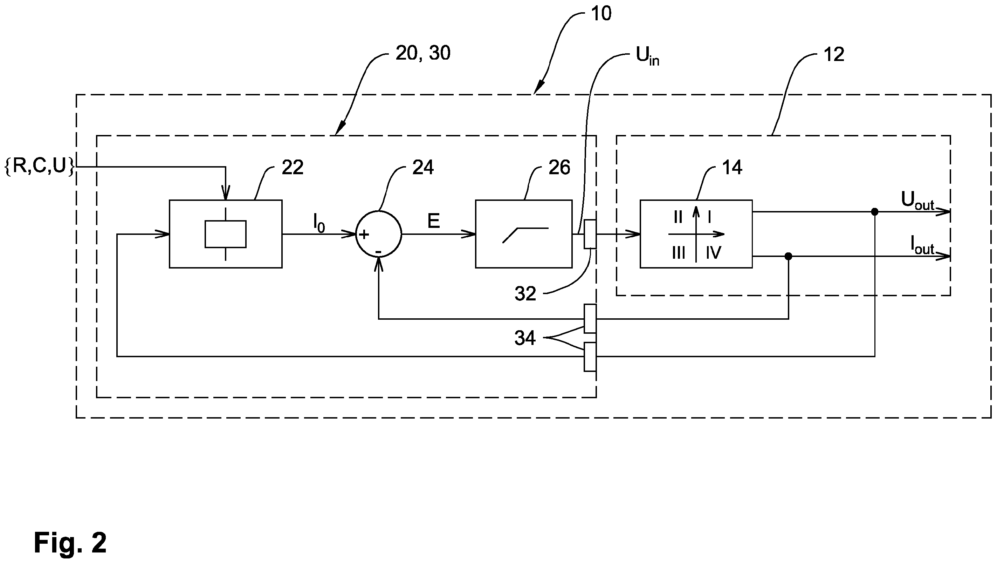

**Fig. 2** zeigt eine erfindungsgemäße Simulationsanordnung 10.

Die erfindungsgemäße Simulationsanordnung 10 umfasst zwei übergeordnete Funktionsblöcke: den spannungsgesteuerten Stromregelkreis 20 und den von dem spannungsgesteuerten Stromregelkreis 20 angesteuerten Zweipol 12. Der Zweipol 12 bildet die elektrischen Eigenschaften des ungeerdeten Stromversorgungssystems 2 nach und ist als 4-Quadranten-Verstärker 14 ausgeführt. Der 4-Quadranten-Verstärker 14 kann als Regelstrecke aufgefasst werden, der als Regelgrößen die Ausgangsspannung $U_{out}$ und den Ausgangsstrom $I_{out}$ erzeugt, die den von dem ungeerdeten Stromversorgungssystem 2 bereitgestellten Spannungs- und Stromwerten entsprechen.

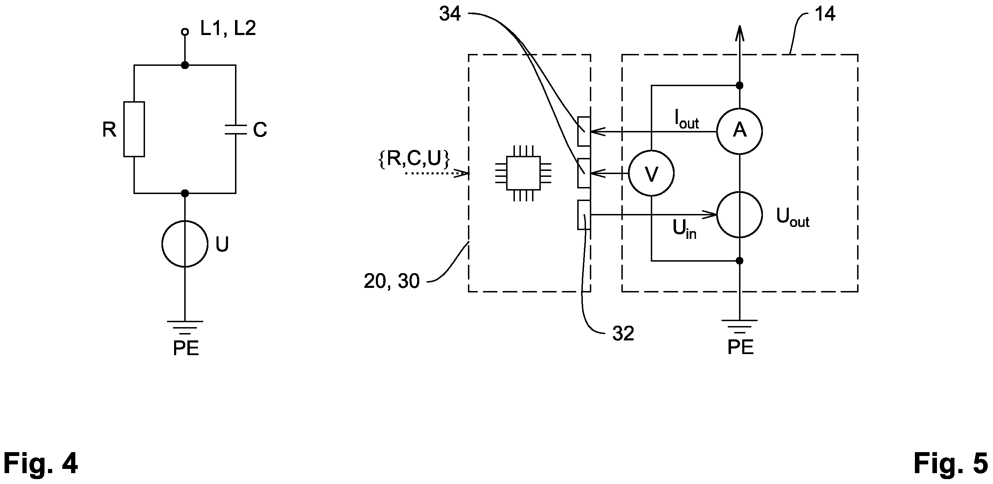

Der spannungsgesteuerte Stromregelkreis 20 weist eingangsseitig ein Zweipol-Modell 22 auf, welches auf Basis der vorgegebenen Größen R, C, U aus einem Ersatzschaltbild (Fig. 4) das ungeerdete Stromversorgungssystem 2 beschreibt. Dazu wird die Ausgangsgröße U_out des 4-Quadranten-Verstärkers 14 über eine Messeinrichtung (nicht dargestellt) und über einen Analog-Digital-Umsetzer 34 dem Zweipol-Modell 22 zugeführt. Aus den das ungeerdete Stromversorgungssystem 2 beschreibenden Größen R, C, U und der zurückgeführten gemessenen Ausgangsspannung U_out wird in dem Zweipol-Modell 22 ein Sollstrom $I_0$ berechnet. Der Sollstrom $I_0$ wird in einem Vergleichsglied 24 mit dem von einer Messeinrichtung (nicht dargestellt) gemessenen und über einen weiteren Analog-Digital-Umsetzer 34 zurückgeführten Ausgangsstrom I_out des 4-Quadranten-Verstärkers 14 verglichen. Als Ergebnis der Vergleichsoperation ergibt sich eine Regelabweichung E, welche auf einen Regler 26 geführt wird.

Der Regler 26 erzeugt aus der Regelabweichung E eine Steuerspannung U_in, die über einen Digital-Analog-Umsetzer 32 dem 4-Quadranten-Verstärker 14 zur Ansteuerung zugeführt wird.

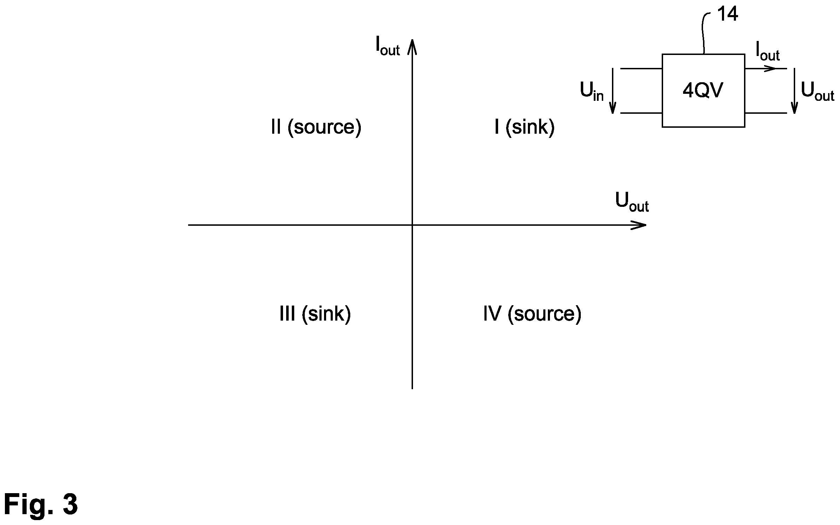

**Fig. 3** zeigt den Arbeitsbereich des 4-Quadranten-Verstärkers 14.

Über die Steuerspannung U_in wird der 4-Quadranten-Verstärker 14 so angesteuert, dass sich ein beliebiger Arbeitspunkt in einem der Quadraten I bis IV einstellt. In Abhängigkeit der Richtung der Ausgangsspannung U_out und des Ausgangsstroms I_out arbeitet der 4-Quadranten-Verstärker 14 in den Quadranten I und III als Senke, in den Quadranten II und IV als Quelle.

**Fig. 4** zeigt ein Ersatzschaltbild des ungeerdeten Stromversorgungssystems 2.

Wie in Fig. 1 dargestellt, kann der Isolationszustand des ungeerdeten Stromversorgungssystems 2 durch den (reellen) Isolationswiderstand R, die Netzableitkapazität C und die Netzspannung U beschrieben werden. Das gezeigte Ersatzschaltbild dient als Basis zur mathematischen Nachbildung in dem Zweipol-Modell 22, jedoch sind auch andere Ersatzschaltbilder als Grundlage der Modellierung möglich. Im vorliegenden Fall ergibt sich der Sollstrom $I_0$, ausgedrückt in zeitdiskreter Darstellung mit der Abtastrate $f_s$ und dem Index n, durch die in dem Zweipol-Modell 22 implementierte Differenzengleichung

$$I_0 = \frac{U_{out,n} - U}{R} + C f_s \left( \left( U_{out,n} - U \right) - \left( U_{out,n-1} - U \right) \right).$$

In **Fig. 5** ist eine Realisierung des spannungsgesteuerten Stromregelkreises 20 als Mikrocontroller 30 dargestellt.

Dazu sind zwei Analog-Digital-Umsetzer 34 zur Rückmessung der Ausgangsspannung U_out und des Ausgangsstroms I_out sowie ein Digital-Anlog-Umsetzer 32 zur Ansteuerung des 4-Quadranten-Verstärkers 14 mittels der Eingangsspannung U_in erforderlich. Empfehlenswert ist eine Auflösung der Umsetzer 32, 34 von mindestens 16 Bit. Die Vorgabewerte R, C, U des Zweipol-Modells 22 in dem spannungsgesteuerten Stromregelkreis 20 können entweder fest in dem Mikrocontroller 30 gespeichert sein oder über eine Datenschnittstelle diesem zugeleitet werden.

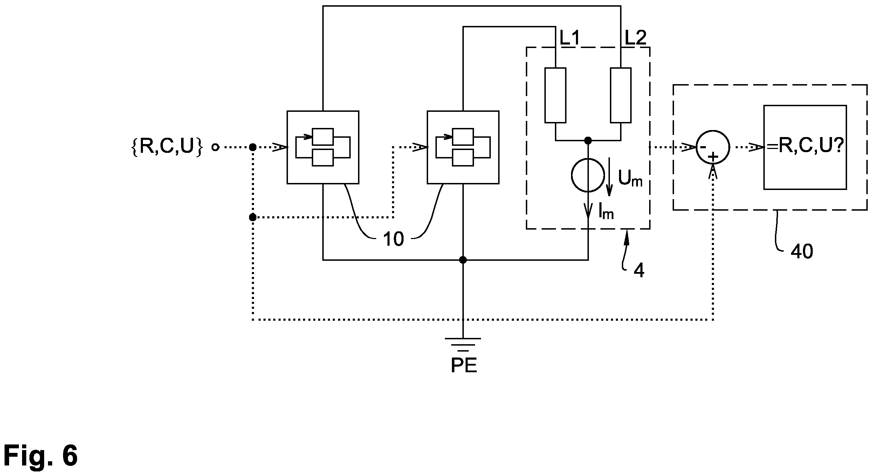

**Fig. 6** zeigt einen Aufbau eines Prüfstandes mit zwei erfindungsgemäßen Simulationsanordnungen 10.

Der Aufbau entspricht einem Hardware-in-the-Loop (HIL) Prüfstand, bei dem für jeden aktiven Leiter L1, L2 eine Simulationsanordnung 10 geschaltet ist. Ein derartiger Aufbau bietet sich bei der Entwicklung zukünftiger Messverfahren für Isolationsüberwachungsgeräte 4 an. Zur Verifikation der vorgegebenen Größen R, C, U mit den entsprechenden simulierten Größen ist eine Vergleichsanordnung 40 vorgesehen.

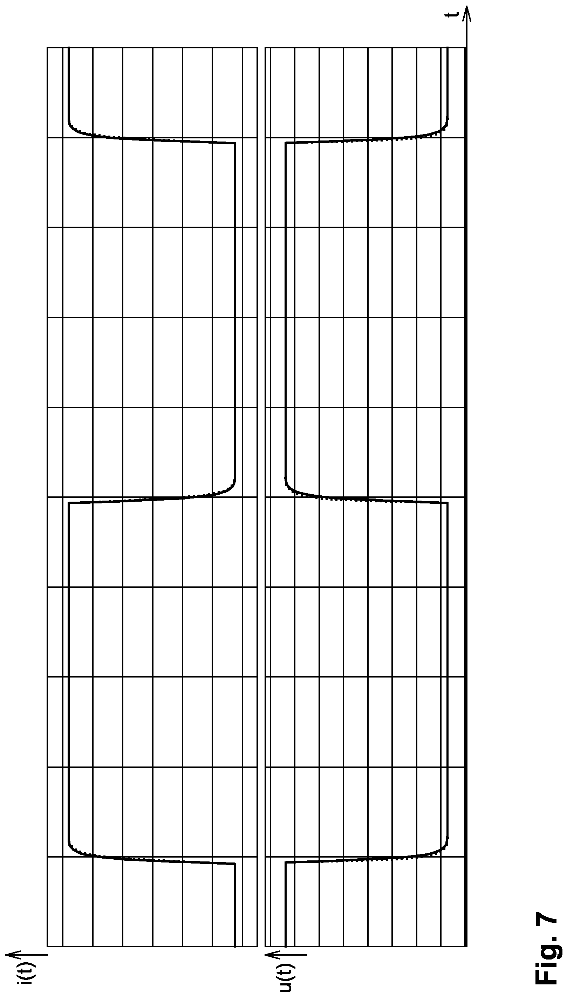

In den **Fig. 7, 8** und **9** sind Simulationsergebnisse dargestellt, in denen die das ungeerdete Stromversorgungssystem 2 beschreibenden Größen R, C sowie eine Fremdspannung in der Simulationsanordnung 10 in jeweils unterschiedlichen Testszenarien aktiviert sind.

Die Signalverläufe zeigen die Reaktion auf rechteckförmige Messimpulse U_m des Isolationsüberwachungsgerätes 4, wobei der obere Kurvenverlauf dem Strom i(t), der untere Kurvenverlauf der Spannung u(t) entspricht.

Zum Vergleich ist dem simulierten Signalverlauf (durchgezogene Linie) jeweils der Signalverlauf eines realen Zweipols (gepunktete Linie) gegenübergestellt.

**Fig. 7** zeigt ein Simulationsergebnis mit rein ohmschen Verhalten des ungeerdeten Stromversorgungssystems 2. Der jeweilige Signalverlauf der Zweipol-Nachbildung und des realen Zweipols sind nahezu deckungsgleich.

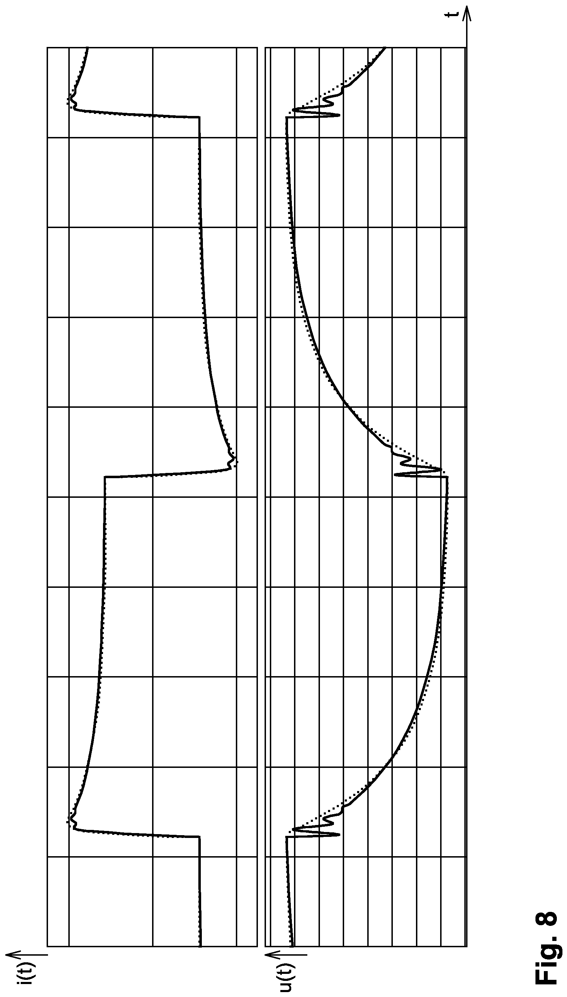

**Fig. 8** zeigt ein Simulationsergebnis mit ohmschen und kapazitiven Verhalten des ungeerdeten Stromversorgungssystems 2.

Auch hier zeigt sich, dass nach einer kurzen Einschwingphase die Zweipol-Nachbildung den realen Zweipol nahezu exakt widerspiegelt.

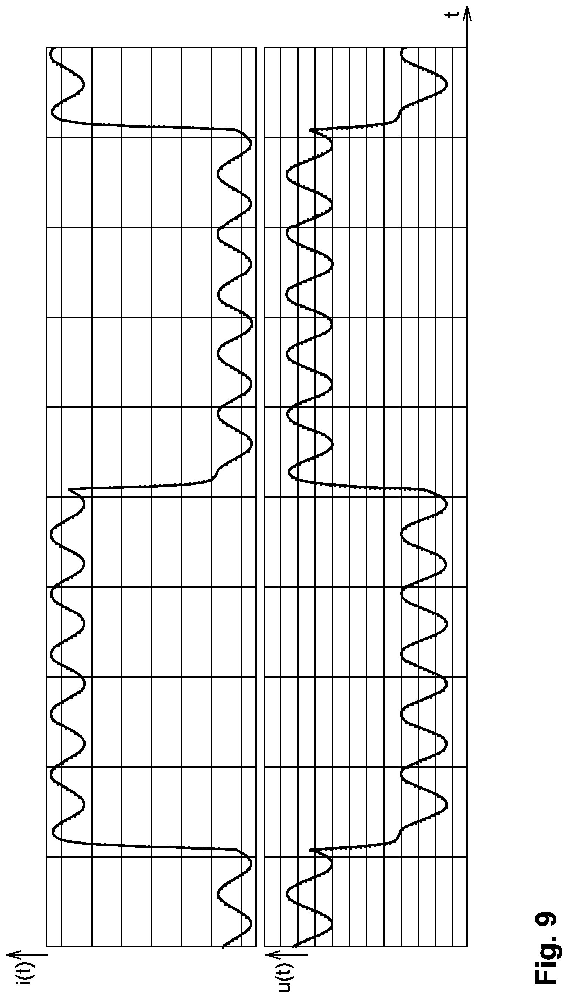

**Fig. 9** zeigt ein Simulationsergebnis mit ohmschen Verhalten und Fremdspannung.

Im Testfall mit einer zusätzlichen sinusförmigen Fremdspannung zeigt sich auch hier, dass mit der Zweipol-Nachbildung die Reaktion auf die Messimpulse U_m ohne merkbare Abweichungen gegenüber der Reaktion bei realem Zweipol abläuft.

**Patentansprüche**

1.  Simulationsanordnung (10) eines ungeerdeten Stromversorgungssystems (2), mit einem Zweipol (12) zur Nachbildung der elektrischen Eigenschaften des ungeerdeten Stromversorgungssystems (2),
    **dadurch gekennzeichnet,**
    **dass** der Zweipol (12) aktiv als 4-Quadranten-Verstärker (14) ausgeführt ist und dass die Simulationsanordnung (10) einen spannungsgesteuerten Stromregelkreis (20) aufweist, der den 4-Quadranten-Verstärker (14) ansteuert.

2.  Simulationsanordnung (10) nach Anspruch 1,
    **dadurch gekennzeichnet,**

    **dass** der spannungsgesteuerte Stromregelkreis (20) aufweist ein Zweipol-Modell (22), welches das ungeerdete Stromversorgungssystem (2) beschreibt und eine von dem 4-Quadranten-Verstärker (14) zurückgeführte gemessene Ausgangsspannung ($U_{out}$) in einen Sollstrom ($I_0$) transformiert,
    ein Vergleichsglied (24), welches den Sollstrom ($I_0$) mit einem von dem 4-Quadranten-Verstärker (14) zurückgeführten gemessenen Ausgangsstrom ($I_{out}$) vergleicht und eine Regelabweichung (E) bildet, und
    einen Regler (26), der aus der Regelabweichung (E) eine Steuerspannung ($U_{in}$) zur Ansteuerung des 4-Quadranten-Verstärkers (14) berechnet.

3.  Simulationsanordnung (10) nach Anspruch 1 oder 2,
    **dadurch gekennzeichnet,**
    **dass** der spannungsgesteuerte Stromregelkreis (20) als Mikrocontroller (30) ausgeführt ist.

4.  Simulationsanordnung (10) nach Anspruch 2 oder 3,
    **dadurch gekennzeichnet,**
    **dass** das Zweipol-Modell (22) ein Ersatzschaltbild des ungeerdeten Stromversorgungssystems (2) beschreibt und als Differenzengleichung zur Berechnung des Sollstroms ($I_0$) implementiert ist.

5.  Simulationsanordnung (10) nach einem der Ansprüche 2 bis 4,
    **dadurch gekennzeichnet,**
    **dass** der Regler (26) als PID-Regler ausgeführt ist.

6.  Verfahren zur Simulation eines ungeerdeten Stromversorgungssystems (2), umfassend die Verfahrensschritte:

    Nachbilden der elektrischen Eigenschaften des ungeerdeten Stromversorgungssystems (2) mittels eines Zweipols (12),
    **gekennzeichnet durch**
    Ansteuern des aktiv als 4-Quadranten-Verstärker (14) ausgeführten Zweipols (12) mittels eines spannungsgesteuerten Stromregelkreises (20).

7.  Verfahren nach Anspruch 6,
    **dadurch gekennzeichnet,**

    **dass** in dem spannungsgesteuerten Stromregelkreis (20) das ungeerdete Stromversorgungssystem (2) mittels eines Zweipol-Modells (22) beschrieben wird,
    eine von dem 4-Quadranten-Verstärker (14) gemessene Ausgangsspannung ($U_{out}$) auf das Zweipol-Modell (22) zurückgeführt wird und in einen Sollstrom ($I_0$) transformiert wird,
    der Sollstrom ($I_0$) mit einem von dem 4-Quadranten-Verstärker (14) zurückgeführten gemessenen Ausgangsstrom ($I_{out}$) mittels eines Vergleichsgliedes verglichen wird und eine Regelabweichung (E) gebildet wird und
    aus der Regelabweichung (E) eine Steuerspannung ($U_{in}$) zur Ansteuerung des 4-Quadranten-Verstärkers (14) mittels eines Reglers (26) berechnet wird.

8.  Verfahren nach Anspruch 6 oder 7,
    **dadurch gekennzeichnet,**
    **dass** die spannungsgesteuerte Stromregelung (20) auf einem Mikrocontroller (30) ausgeführt wird.

9.  Verfahren nach Anspruch 7 oder 8,
    **dadurch gekennzeichnet,**

**dass** durch das Zweipol-Modell (22) ein Ersatzschaltbild des ungeerdeten Stromversorgungssystems (2) beschrieben wird und durch eine Differenzengleichung zur Berechnung des Sollstroms ($I_0$) implementiert ist.

10. Verfahren nach einem der Ansprüche 7 bis 9,
    **dadurch gekennzeichnet,**
    **dass** der Regler (26) einen PID-Regelalgorithmus ausführt.

**Fig. 1**
Stand der Technik

**Fig. 2**

**Fig. 3**

**Fig. 4**

**Fig. 5**

EP 4 624 944 A1

Fig. 6

**Fig. 7**

i(t)

u(t)

t

Fig. 8

**Fig. 9**

EP 4 624 944 A1

Europäisches
Patentamt

European
Patent Office

Office européen
des brevets

**EUROPÄISCHER RECHERCHENBERICHT**

Nummer der Anmeldung

EP 25 16 0148

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | EP 1 589 345 A1 (EAN ELEKTROSCHALTANLAGEN GRIMM [DE]) 26. Oktober 2005 (2005-10-26) * Zusammenfassung; Abbildungen 1-4 * * Absätze [0007] - [0022] * ----- | 1-10 | INV. G01R27/02 G01R31/28 G01R27/18 |
| A | SCHULZE WOLF ET AL: "Emulation of grid-forming inverters using real-time PC and 4-quadrant voltage amplifier", FORSCHUNG IM INGENIEURWESEN: ENGINEERING RESEARCH, SPRINGER-VERLAG, BERLIN, DE, Bd. 85, Nr. 2, 27. April 2021 (2021-04-27) , Seiten 425-430, XP037458529, ISSN: 0015-7899, DOI: 10.1007/S10010-021-00484-9 [gefunden am 2021-04-27] * Abschnitte 3-5 * ----- | 1-10 | |

RECHERCHIERTE SACHGEBIETE (IPC)

G01R

Der vorliegende Recherchenbericht wurde für alle Patentansprüche erstellt

| Recherchenort | Abschlußdatum der Recherche | Prüfer |
|---|---|---|
| München | 7. August 2025 | Kleiber, Michael |

## ANHANG ZUM EUROPÄISCHEN RECHERCHENBERICHT
## ÜBER DIE EUROPÄISCHE PATENTANMELDUNG NR.

EP 25 16 0148

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

07-08-2025

| Im Recherchenbericht angeführtes Patentdokument | Datum der Veröffentlichung | Mitglied(er) der Patentfamilie | Datum der Veröffentlichung |
|---|---|---|---|
| EP 1589345 A1 | 26-10-2005 | CN 1721869 A | 18-01-2006 |
| | | DE 102004018918 B3 | 28-07-2005 |
| | | EP 1589345 A1 | 26-10-2005 |
| | | EP 1593983 A1 | 09-11-2005 |
| | | HK 1085793 A1 | 01-09-2006 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3246715 B1
- DE 102020111807 B9